(19) **Europäisches Patentamt**
European Patent Office
Office européen des brevets

(11) **EP 2 774 242 B1**

(12) **EUROPÄISCHE PATENTSCHRIFT**

(45) Veröffentlichungstag und Bekanntmachung des Hinweises auf die Patenterteilung:
**16.03.2016 Patentblatt 2016/11**

(21) Anmeldenummer: **11805472.5**

(22) Anmeldetag: **16.12.2011**

(51) Int Cl.:
***H02J 3/24*** *(2006.01)*

(86) Internationale Anmeldenummer:
**PCT/EP2011/073071**

(87) Internationale Veröffentlichungsnummer:
**WO 2013/087122 (20.06.2013 Gazette 2013/25)**

(54) **VERFAHREN ZUM ERZEUGEN EINES EINE PENDELUNG IN EINEM ELEKTRISCHEN ENERGIEVERSORGUNGSNETZ ANGEBENDEN SIGNALS**

METHOD FOR GENERATING A SIGNAL INDICATING AN OSCILLATION IN AN ELECTRICAL ENERGY SUPPLY NETWORK

PROCÉDÉ DE GÉNÉRATION D'UN SIGNAL INDIQUANT UNE OSCILLATION DANS UN RÉSEAU DE DISTRIBUTION D'ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**10.09.2014 Patentblatt 2014/37**

(73) Patentinhaber: **Siemens Aktiengesellschaft 80333 München (DE)**

(72) Erfinder:
• LITZINGER, Andreas
  **90765 Fürth (DE)**
• PIEL, Stefan
  **45359 Essen (DE)**

(56) Entgegenhaltungen:
**EP-A1- 2 302 754    WO-A1-2011/032579**

## Beschreibung

Die Erfindung betrifft ein Verfahren zum Erzeugen eines eine Pendelung in einem elektrischen Energieversorgungsnetz angebenden Signals.

Um einen reibungslosen und sicheren Betrieb elektrischer Energieversorgungsnetze zu gewährleisten, werden in sogenannten Netzleitstellen für den Netzzustand charakteristische Messwerte des elektrischen Energieversorgungsnetzes überwacht, um zu ermitteln, ob sich das Energieversorgungsnetz in seinem bestimmungsgemäßen Betriebszustand oder aber einem kritischen Zustand befindet. Hierzu werden an ausgewählten Messstellen des elektrischen Energieversorgungsnetzes Messwerte elektrischer Messgrößen, wie z.B. Strom, Spannung und Leistung, mittels geeigneter Wandler erfasst und üblicherweise in digitaler Form der Netzleitstelle zur Auswertung und Beobachtung zugeführt. Um einen zeitlichen Bezug der einzelnen Messwerte zueinander zu gewährleisten, werden die aufgenommenen Messwerte üblicherweise um sogenannte Zeitstempel, also Uhrzeitinformationsdaten, ergänzt, die z.B. diejenige Uhrzeit angeben, zu denen die Messwerte erfasst worden sind. Solche Zeitstempel können beispielsweise mit einer Genauigkeit von einer Millisekunde vergeben werden.

Ein Verfahren zum Überwachen eines elektrischen Energieversorgungsnetzes hinsichtlich kritischer Netzzustände ist beispielsweise aus der WO 2011/032579 A1 bekannt.

Eine Form eines kritischen Betriebszustands eines elektrischen Energieversorgungsnetzes stellen sogenannte "Leistungspendelungen" (im Folgenden schlicht als "Pendelungen" bezeichnet) dar. Solche Pendelungen entstehen z. B. bei plötzlichen Laständerungen oder Veränderungen an der Struktur des elektrischen Energieversorgungsnetzes (beispielsweise durch Zu- oder Abschalten größerer Netzteile). Hierbei müssen sich die Generatoren an den Einspeisestellen des elektrischen Energieversorgungsnetzes auf die neue Lastsituation einstellen. Dies geschieht üblicherweise in Form einer gedämpften Schwingung mit einer Frequenz von wenigen Hertz, bis sich der neue Arbeitspunkt des elektrischen Energieversorgungsnetzes stabilisiert hat. Durch das Einschwingverhalten der Generatoren werden pendelnde Strom- und Spannungszustände im Energieversorgungsnetz erzeugt, die unterschiedliche Auswirkungen auf das Energieversorgungsnetz und seine elektrischen Komponenten (z.B. Leitungen, Kabel, Transformatoren) haben können. Während gedämpfte Pendelungen mit vergleichsweise niedrigen Amplituden im Energieversorgungsnetz relativ schnell abklingen und daher akzeptiert werden können, stellen insbesondere schwach gedämpfte oder sogar sich aufschaukelnde Pendelungen einen höchst kritischen Zustand des Energieversorgungsnetzes dar, der leicht zu Ausfällen und Abschaltungen größerer Netzabschnitte führen kann. Außerdem kann durch die sich bei Ausfällen einzelner Netzabschnitte sprunghaft verändernde Netzstruktur eine Überlastung noch funktionsfähiger Abschnitte des elektrischen Energieversorgungsnetzes erfolgen, was zu kaskadierenden Abschaltungen bis hin zu einem sogenannten Blackout führen kann. Daher sind insbesondere solche als kritisch einzustufenden Pendelungen unverzüglich dem Leistellen-Betriebspersonal des elektrischen Energieversorgungsnetzes zu signalisieren.

Mit steigender Anzahl von Messstellen und kürzeren Abtastintervallen bei der Erfassung der Messwerte steigt die Anzahl der von dem Betriebspersonal in Netzleitstellen zu überwachenden Messwerte in den letzten Jahren rapide an und wird voraussichtlich in der Zukunft noch eine weitere Steigerung erfahren. Insbesondere beim Ausbau von Energieversorgungsnetzen zu sogenannten "Smart Grids" fallen Messwerte in einer solchen Anzahl an, die die Messwertanzahl von herkömmlichen Überwachungssystemen für Energieversorgungsnetze um Größenordnungen übersteigt. Hierbei werden Messwerte beispielsweise mit sogenannten Zeigermesseinrichtungen bzw. "Phasor Measurement Units" (PMU) als komplexe Strom- oder Spannungszeiger erfasst, die eine Aussage über Amplitude und Phasenwinkel der an der jeweiligen Messstelle des elektrischen Energieversorgungsnetzes zu messenden Messgröße umfassen. Solche Zeigermesswerte werden mit hohen Abtastraten erfasst, um z.B. Lastflüsse und mögliche Netzpendelungen noch genauer erkennen zu können und ggf. geeignete Gegenmaßnahmen zur Abwendung sich ankündigender instabiler Zustände einzuleiten. Ein beispielhaftes Verfahren, mit dem anhand von Zeigermesswerten durch kontinuierliche Anpassung von Parametern eines mathematischen Berechnungsmodells auf das Vorliegen von Pendelungen in einem Energieversorgungsnetz geschlossen werden kann, ist aus der Europäischen Patentschrift EP 1489714 B1 bekannt.

Aufgrund der großen Anzahl darstellbarer Messwerte und der daraus resultierenden Vielfalt möglicher von dem Betriebspersonal zu überblickender Betriebszustände des elektrischen Energieversorgungsnetzes stellt sich die Frage, welche Abweichungen vom stabilen Betriebszustand als Alarmsignale (z.B. in Form von Meldungen auf einer Workstation der Leitstelle) angezeigt werden müssen. Hierbei besteht die Anforderung, dass einerseits zu jeder Zeit ein stabiler und ordnungsgemäßer Betrieb des Energieversorgungsnetzes gewährleistet sein muss, andererseits aber auch Häufigkeit und Inhalte der Alarmsignale so gewählt sein müssen, dass dem Betriebspersonal eine hinreichende Information über den jeweiligen Netzzustand gegeben wird, ohne es durch zu häufige Alarmierungen und/oder einen zu hohen Grad der Detailliertheit der mit den Alarmsignalen zur Verfügung gestellten Informationen zu überfordern.

In bisherigen Systemen zur Erkennung von Pendelungen in Energieversorgungsnetzen wird zumeist mit einem einfachen Schwellenwertsystem gearbeitet. Hierbei werden bestimmte Messgrößen (z.B. Frequenz oder Amplitude von gemessenen Strom-, Spannungs- oder Leistungsverläufen) hinsichtlich eines Schwellenwertes ausgewertet und bei einer Schwellenwertüberschreitung ein Alarmsignal ausgelöst. Dem Betriebspersonal bleibt es dann überlassen, sich die zur Beurteilung der jeweiligen Schwere des Gefährdungszustands benötigten Informationen selbst zusammenzustellen und zu beurteilen, ob durch das jeweilige ggf. netzstabilisierende Maßnahmen erforderlich werden oder nicht.

Der Erfindung liegt daher die Aufgabe zugrunde, dem Betriebspersonal in einer Leitstelle eines elektrischen Energieversorgungsnetzes eine Information über etwaige in dem Energieversorgungsnetz aufgetretene Pendelungen in geeigneter Art und Weise zu Verfügung zu stellen und dem Betriebspersonal damit eine sicherere Betriebsführung des Energieversorgungsnetzes zu ermöglichen.

Diese Aufgabe wird erfindungsgemäß durch ein Verfahren zum Erzeugen eines eine Pendelung einer elektrischen Größe (z.B. Strom, Spannung, Leistung, Impedanz) in einem elektrischen Energieversorgungsnetz angebenden Signals gelöst, bei dem zeitlich synchron Strom- und oder Spannungszeigermesswerten an zumindest einer Messstelle in dem elektrischen Energieversorgungsnetz mittels einer jeweiligen Zeigermesseinrichtung erfasst werden. Die Strom- und/oder Spannungszeigermesswerte werden an eine das Energieversorgungsnetz überwachende Leitstelleneinrichtung übermittelt; die Leitstelleneinrichtung berechnet eine einen Pendelungszustand der elektrischen Größe (z.B. Strom, Spannung, Leistung, Impedanz) charakterisierende Zustandsgröße aus zueinander gehörenden Strom- und/oder Spannungszeigermesswerten und untersucht einen Verlauf der Zustandsgröße hinsichtlich einer vorliegenden Pendelung im Energieversorgungsnetz. Bei vorliegender Pendelung der Zustandsgröße werden durch die Leitstelleneinrichtung ein eine Amplitude des Verlaufs der Zustandsgröße angebender Amplitudenkennwertes und ein eine Dämpfung einer Schwingung des Verlaufs der Zustandsgröße angebender Dämpfungskennwertes ermittelt. Aus einem Amplitudenkennwert und einem zugehörigen Dämpfungskennwert bestehende Wertepaare werden mit in einem Wertebereich vorliegenden, einen jeweiligen Gefährdungsgrad der Pendelung in dem Energieversorgungsnetz angebenden Gefährdungsbereichen unter Ermittlung einer Gefährdungskenngröße verglichen und das die Pendelung angebende Signal wird in Abhängigkeit von der Gefährdungskenngröße ausgegeben.

Mit dem erfindungsgemäßen Verfahren kann auf vergleichsweise einfache Art und Weise ein mehrstufiges Alarmierungssystem realisiert werden, da das jeweils ausgegebene die Pendelung angebende Signal in Abhängigkeit von der jeweiligen erkannten Gefährdungsstufe ausgegeben wird. Hierdurch wird dem Betriebspersonal unmittelbar mit dem die Pendelung angebenden Signal eine differenzierte Information über die mit der aktuellen Pendelung verbundene Gefährdung gegeben.

Eine vorteilhafte Ausführungsform des erfindungsgemäßen Verfahrens sieht vor, dass die Zustandsgröße eine an einer Messstelle in dem Energieversorgungsnetz vorliegende Wirkleistung angibt. Alternativ dazu kann auch vorgesehen sein, dass die Zustandsgröße eine Phasenwinkeldifferenz angibt, die einen von Spannungszeigermesswerten eingeschlossenen Phasenwinkel bezeichnet, wobei die Spannungszeigermesswerte an zwei unterschiedlichen Messstellen in dem Energieversorgungsnetz zeitlich synchron erfasst worden sind. Die beschriebenen Ausführungsformen stellen Zustandsgrößen dar, die zur Beurteilung einer etwaig vorliegenden Pendelung besonders geeignet sind.

Gemäß einer weiteren vorteilhaften Ausführungsform des erfindungsgemäßen Verfahrens ist zudem vorgesehen, dass der Dämpfungskennwert in Abhängigkeit von der aktuellen Frequenz der Zustandsgröße ermittelt wird.

Hierdurch kann der Dämpfungskennwert besonders gut an die jeweils vorliegende Pendelsituation angepasst werden. Der Dämpfungskennwert kann beispielsweise gemäß der folgenden Gleichung bestimmt werden:

$$\xi = -100 \frac{\alpha}{\sqrt{\alpha^2 + \omega^2}} \, ,$$

wobei $\xi$ der in Prozent angegebene Dämpfungskennwert ist, $\alpha$ die in 1/s angegebene Dämpfung einer exponentiell abklingenden (oder anwachsenden) Schwingung darstellt und $\omega$ die in 1/s angegebene Kreisfrequenz angibt. Durch die Aufnahme der Kreisfrequenz $\omega$ in die Gleichung für den Dämpfungskennwert ergibt sich dessen Abhängigkeit von der aktuellen Frequenz der Schwingung der Zustandsgröße.

Gemäß einer weiteren vorteilhaften Ausführungsform des erfindungsgemäßen Verfahrens ist vorgesehen, dass das die Pendelung angebende Signal nur dann ausgegeben wird, wenn der Amplitudenkennwert und/oder der zugehörige Dämpfungskennwert jeweils einen vorgegebenen Schwellenwert überschreiten.

Hierdurch kann die Ausgabe eines die Pendelung angebenden Signals immer dann unterdrückt werden, wenn durch die Pendelung kein die Stabilität des Energieversorgungsnetzes beeinträchtigender Zustand hervorgerufen wird. Sobald jedoch bezüglich eines folgenden Wertepaares der Amplitudenkennwert und/oder der Dämpfungskennwert ihren jeweiligen Schwellenwert überschreiten, wird das die Pendelung angebende Signal entsprechend ausgegeben.

Eine weitere vorteilhafte Ausführungsform des erfindungsgemäßen Verfahrens sieht zudem vor, dass das die Pendelung angebende Signal Angaben über die aktuelle Frequenz der Zustandsgröße, den aktuellen Amplitudenkennwert der Zustandsgröße, den aktuellen Dämpfungskennwert der Zustandsgröße und/oder die Gefährdungskenngröße enthält.

Hierdurch können dem Betriebspersonal in der Leitstelle direkt mit dem die Pendelung angebenden Signal die wichtigsten Informationen zur Verfügung gestellt werden, um den aktuellen Zustand des Energieversorgungsnetzes zu beurteilen. Dabei kann das die Pendelung angebende Signal beispielsweise als text- und/oder grafikbasierte Meldung auf einer Anzeigeeinrichtung einer Workstation ausgegeben werden, die die jeweils nötigen Zusatzinformationen beinhaltet.

Gemäß einer weiteren vorteilhaften Ausführungsform des erfindungsgemäßen Verfahrens ist vorgesehen, dass das die Pendelung angebende Signal in Abhängigkeit von Gefährdungskenngröße in unterschiedlicher Weise ausgegeben wird.

Auf diese Weise kann bereits bei der Ausgabe des Signals auf den jeweils unterschiedlichen Gefährdungsgrad hingewiesen werden. So können die Signale beispielsweise als einfache Textmeldung bei einer niedrigen Gefährdungsstufe, als Textmeldung mit zusätzlicher Warnfunktion (z.B. Farbmarkierung, Blinken) bei einer mittleren Gefährdungsstufe und als Textmeldung mit zusätzlichem optischem und/oder akustischem Warnhinweis bei einer hohen Gefährdungsstufe ausgegeben werden.

Eine weitere vorteilhafte Ausführungsform des erfindungsgemäßen Verfahrens sieht außerdem vor, dass das die Pendelung angebende Signal nur dann ausgegeben wird, wenn die Gefährdungskenngröße auch nach Ablauf einer vorgegebenen Verzögerungszeitdauer einen vorgegebenen Minimalwert nicht unterschritten hat.

Hierdurch kann durch die Leitstelleneinrichtung zunächst verifiziert werden, ob überhaupt eine andauernde Pendelung vorliegt und erst bei anhaltender Pendelung das Signal ausgegeben werden. Auf diese Weise wird das Betriebspersonal nicht mit unnötig häufigen Alarmen belastet. Die Verzögerungszeitdauer kann hierbei fest oder als von der Pendelfrequenz abhängiger Wert (z.B. nach Ablauf einer bestimmten Anzahl von Schwingungsdauern der Pendelung) vorgegeben werden.

Gemäß einer weiteren vorteilhaften Ausführungsform des erfindungsgemäßen Verfahrens ist zudem vorgesehen, dass zeitliche Verläufe der Frequenz der Zustandsgröße, des Amplitudenkennwertes der Zustandsgröße, des Dämpfungskennwertes der Zustandsgröße und/oder einer Angabe der jeweiligen Gefährdungskenngröße in einer Speichereinrichtung der Leitstelleneinrichtung abgespeichert werden.

Das Abspeichern der entsprechenden zeitlichen Verläufe erlaubt auch im Nachhinein eine genaue Analyse der Vorgänge in dem elektrischen Energieversorgungsnetz, so dass etwaige Störungen nachvollzogen werden können.

Gemäß einer weiteren vorteilhaften Ausführungsform des erfindungsgemäßen Verfahrens ist schließlich vorgesehen, dass aus der Gefährdungskenngröße und einem von dem Amplitudenkennwert der Zustandsgröße abhängigen Amplitudenparameter sowie einem von dem Dämpfungskennwert der Zustandsgröße abhängigen Dämpfungsparameter eine Gefährdungsgröße berechnet wird, deren Verlauf in einer Speichereinrichtung der Leitstelleneinrichtung abgespeichert wird.

Auf diese Weise kann der jeweilige Gefährdungsgrad einer Pendelung für eine spätere Analyse nicht nur als diskreter Wert entsprechend des jeweiligen Gefährdungsbereiches angegeben werden, sondern unter Verwendung des Amplitudenparameters und des Dämpfungsparameters als quasi-kontinuierlicher Wert innerhalb des jeweiligen Gefährdungsbereiches abgespeichert werden. Die Verknüpfung aus Amplituden- und Dämpfungsparameter ist dabei vorzugsweise derart gewählt, dass ein Wert zwischen 0 und 1 erreicht werden kann. Addiert man diesen Wert zu dem Wert des jeweiligen Gefährdungsbereiches, so ergibt sich ein quasi-kontinuierlicher Verlauf der Gefährdungsgröße, der nur an den Übergangsstellen zwischen zwei Gefährdungsbereichen einen diskontinuierlichen Verlauf aufweist.

Die Erfindung soll im Folgenden anhand eines Ausführungsbeispiels näher erläutert werden. Hierzu zeigen

Figur 1    ein Ausführungsbeispiel eines Automatisierungssystems zur Überwachung eines elektrischen Energieversorgungsnetzes;

Figur 2    einen zeitlichen Verlauf einer Zustandsgröße in Form einer Wirkleistung;

Figur 3    einen zeitlichen Verlauf einer Zustandsgröße in Form einer Phasenwinkeldifferenz; und

Figur 4    ein Diagramm zur Ermittlung der jeweiligen Gefährdungsstufe einer Pendelung.

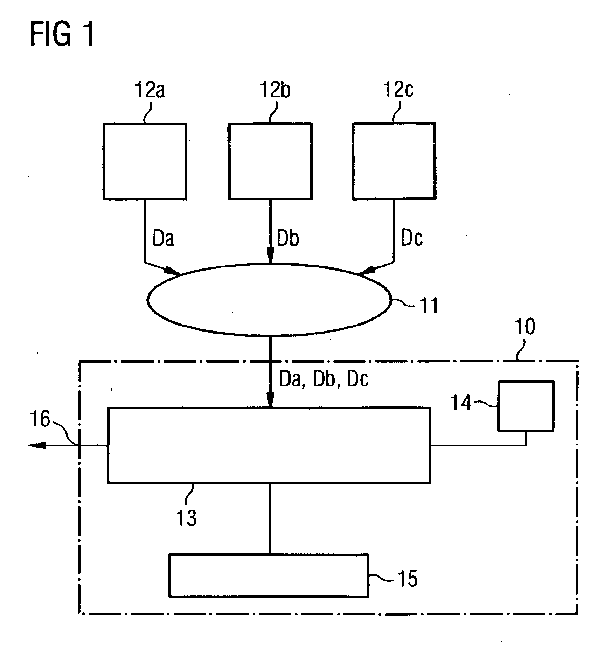

In der Figur 1 erkennt man eine Anordnung mit einer Leitstelleneinrichtung 10, z.B. eine Datenverarbeitungseinrichtung in einer Netzleitstelle, die über ein Datenübertragungsnetzwerk 11 mit drei Zeigermesseinrichtungen 12a, 12b und 12c in Verbindung steht. Bei den Zeigermesseinrichtungen 12a-c handelt es sich beispielsweise um so genannte "Phasor Measurement Units" (PMU), die Strom- und/oder Spannungsmesswerte an Messstellen eines in der Figur 1 nicht weiter dargestellten Energieversorgungsnetzes erfassen und daraus entsprechende Strom- und/oder Spannungszeigermesswerte erzeugen. Ein Zeigermesswert stellt hierbei einen Messwert dar, der in einer komplexen Zahlenebene aufgetragen werden kann und der eine Angabe über die aktuelle Amplitude und den aktuellen Phasenwinkel der jeweiligen Messgröße (hier Strom bzw. Spannung) umfasst. Die Zeigermesswerte werden zusammen mit einer Angabe über den jeweiligen Messzeitpunkt in Form von Datensätzen $D_a$, $D_b$ und $D_c$ über das Datenübertragungsnetzwerk 11 zu der Leitstelleneinrichtung 10 übertragen. Die Anzahl von drei Zeigermesseinrichtungen wurde in dem Ausführungsbeispiel gemäß Figur 1 lediglich beispielhaft gewählt, selbstverständlich sind Konfigurationen von Anordnungen mit beliebig vielen Zeigermesseinrichtungen möglich.

Nachfolgend wird beispielhaft davon ausgegangen, dass die Zeigermesseinrichtung 12a zum Messen von Stromzeigermesswerten und Spannungszeigermesswerten eingerichtet ist und entsprechend in ihren Datensätzen $D_a$ jeweils einen Spannungszeigermesswert sowie einen zugehörigen Stromzeigermesswert zu der Leitstelleneinrichtung 10 überträgt. Die Zeigermesseinrichtungen 12b und 12c seien zur Erfassung von Spannungszeigermesswerten eingerichtet und übertragen entsprechend Datensätze $D_b$ und $D_c$ an die Leitstelleneinrichtung 10, die jeweils einen Spannungszeigermesswert enthalten.

Die Leitstelleneinrichtung 10 umfasst eine Auswerteinrichtung 13, die ihrerseits mit einer Konfigurationseinrichtung 14 sowie einer Speichereinrichtung 15 in Verbindung steht. Die Leitstelleneinrichtung kann darüber hinaus über einen Signalausgang 16 ein eine Pendelung angebendes Signal an eine in Figur 1 nicht dargestellte Bedieneinrichtung (z.B. eine Workstation mit einem Display) der Netzleitstelle ausgeben. Dabei kann die Bedieneinrichtung sowohl ein externes Gerät als auch ein integraler Bestandteil der Leitstelleneinrichtung 10 sein.

Die Anordnung gemäß Figur 1 kann beispielsweise wie folgt betrieben werden:

Die Leitstelleneinrichtung 10 wertet die von den Messeinrichtungen 12a-c empfangenen Datensätze $D_a$, $D_b$ und $D_c$ aus und verarbeitet somit die übertragenen Strom- und Spannungszeigermesswerte. Da in den Datensätzen $D_a$, $D_b$ und $D_c$ auch jeweils die jeweiligen Messzeitpunkte enthalten sind, kann die Leitstelleneinrichtung 10 für jeden Zeigermesswert auch den jeweiligen Messzeitpunkt feststellen.

Die Leitstelleneinrichtung 10 stellt die entsprechenden Zeigermesswerte der Auswerteinrichtung 13 zur Verfügung, so dass diese auf die entsprechenden Zeigermesswerte zugreifen kann. Die Leitstelleneinrichtung 10 speichert die Zeigermesswerte auch in der Speichereinrichtung 15 ab, um diese bei Bedarf für eine spätere Auswertung bereitstellen zu können.

Die Auswerteinrichtung 13 bestimmt aus zeitlich zueinander gehörenden Strom- bzw. Spannungszeigermesswerten eine einen Pendelungszustand des elektrischen Energieversorgungsnetzes charakterisierende Zustandsgröße. Bei der Zustandsgröße kann es sich beispielsweise um eine Wirkleistung oder um eine Phasenwinkeldifferenz handeln. Für die Wirkleistung werden an einer Messstelle im Energieversorgungsnetz gemessene Strom- und Spannungszeigermesswerte verwendet; die Wirkleistung wird hierbei als Produkt eines Spannungszeigermesswertes und eines zeitlich zugehörigen Stromzeigermesswertes bestimmt. Beispielsweise können hierzu die in dem Datensatz $D_a$ enthaltenen Spannungs- und Stromzeigermesswerte der Zeigermesseinrichtung 12a verwendet werden. Für die Phasenwinkeldifferenz werden an zwei verschiedenen Messstellen im Energieversorgungsnetz zeitlich synchron gemessene Spannungszeigermesswerte hinsichtlich ihres den Phasenwinkel angebenden Anteils miteinander verglichen und die Phasenwinkeldifferenz berechnet. Beispielsweise können hierfür die Spannungszeigermesswerte verwendet werden, die von den Zeigermesseinrichtungen 12b und 12c erfasst und mit den Datensätzen $D_b$ und $D_c$ an die Leitstelleneinrichtung 10 übertragen werden.

Die Leitstelleneinrichtung 10 kann mittels der Auswerteinrichtung 13 entweder eine der beiden Zustandsgrößen oder auch beide Zustandsgrößen berechnen und diese hinsichtlich des Vorliegens einer Pendelung im elektrischen Energieversorgungsnetz untersuchen. Außerdem kann die jeweils berechnete Zustandsgröße (z.B. in Form der Phasenwinkeldifferenz oder der Wirkleistung) zur späteren Analyse in der Speichereinrichtung 15 gespeichert werden.

Zur Untersuchung der Zustandsgröße hinsichtlich einer im Energieversorgungsnetz vorliegenden Pendelung werden die jeweils zur Berechnung der Zustandsgröße benötigten Strom- bzw. Spannungszeigermesswerte über vorgewählte Zeitbereiche akkumuliert. Diese Werte werden bei Vollständigkeit der Daten z.B. unter Verwendung einer Fast Fourier Transformation (FFT) oder Discrete Fourier Transformation (DFT) in den Frequenzbereich transformiert, um ggf. die für die zu erkennenden Pendelvorgänge charakteristischen Frequenzen zu identifizieren. Da gleichzeitig mehrere Frequenzen ("Moden") angeregt sein können, kann die Auswerteinrichtung mehrere Moden gleichzeitig identifizieren und berechnen. Die maximale Anzahl der erwarteten Moden und ihre typischen Frequenzbereiche können in der Konfigurationseinrichtung 14 vom Betriebspersonal festgelegt werden.

Für jede bei der Untersuchung erkannte angeregte Frequenz werden der aktuelle Wert der zeitlich veränderlichen Amplitude in Form eines Amplitudenkennwertes und der aktuelle Wert eines Dämpfungsfaktors in Form eines Dämpfungskennwertes berechnet. Je nach angeregter Frequenz muss hierbei über einen längeren Zeitraum gemessen werden, um den Amplitudenkennwert und den Dämpfungskennwert eindeutig bestimmen zu können. Zur Bestimmung des Dämpfungskennwertes wird von der Auswerteinrichtung die folgende Beziehung herangezogen

$$\hat{A}(t) \sim \exp(-\alpha t),$$

wobei $\hat{A}(t)$ die zeitlich veränderliche Amplitude (Amplitudenkennwert) der schwingenden Zustandsgröße ist und $\alpha$ die Dämpfung der Schwingung in 1/s angibt. Je nach Wert von $\alpha$ kann der Amplitudenkennwert der schwingenden Zustandsgröße entweder abnehmen ($\alpha$ positiv), gleich bleiben ($\alpha$ = Null) oder zunehmen ($\alpha$ negativ).

Eine für die möglichen Auswirkungen einer Pendelung im Energieversorgungsnetz wesentliche Kenngröße ist der auf die Pendelfrequenz bezogene Dämpfungsfaktor $\xi$, im Folgenden vereinfachend als Dämpfungskennwert bezeichnet. Der Dämpfungskennwert ist dimensionslos und wird nachfolgend in Prozent angegeben. Der Dämpfungskennwert kann beispielsweise gemäß der folgenden Gleichung bestimmt werden:

$$\xi = -100 \frac{\alpha}{\sqrt{\alpha^2 + \omega^2}} \, ,$$

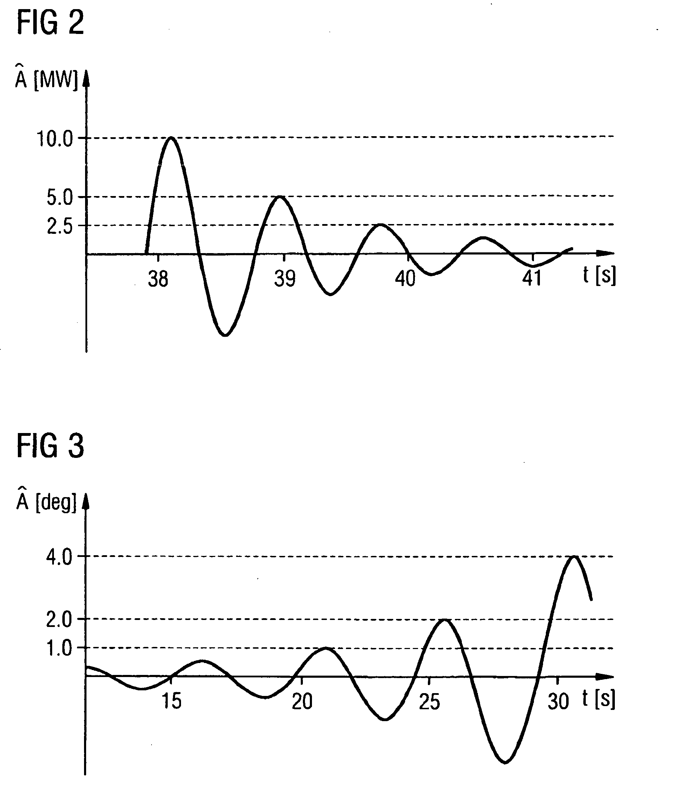

wobei $\xi$ der in Prozent angegebene Dämpfungskennwert ist und $\omega$ die in 1/s angegebene Kreisfrequenz der schwingenden Zustandsgröße angibt. Durch die Aufnahme der Kreisfrequenz $\omega$ in die Gleichung für den Dämpfungskennwert ergibt sich dessen Abhängigkeit von der aktuellen Frequenz der Schwingung der Zustandsgröße. So gibt der Dämpfungskennwert - unabhängig von der Frequenz der Pendelung - ein relatives Maß für die Amplitudenänderung der Pendelung von einem beliebigen Maximum zum nächsten an. Eine negative Dämpfung $\xi$ ist hierbei charakteristisch für eine in der Amplitude abklingende Pendelung. In Figur 2 ist lediglich beispielhaft zur Veranschaulichung ein entsprechender zeitlicher Verlauf des Amplitudenkennwertes $\hat{A}$ einer Zustandsgröße in Form einer Wirkleistung gezeigt. Der Dämpfungskennwert $\xi$ der gezeigten Pendelung liegt bei -10 %. Die erkannte angeregte Frequenz liegt bei 1,2 Hz. Eine Pendelung der Zustandsgröße mit einem Dämpfungskennwert $\xi$ unterhalb von -5 % wird üblicherweise bei nicht zu großer Amplitude als unkritisch betrachtet. Dämpfungsfaktoren oberhalb von -3 % hingegen können, insbesondere bei weiteren Anregungen im Energieversorgungsnetz zu einem schnellen Anwachsen der Amplitude führen und müssen daher unter besonderer Beobachtung stehen.

Ungedämpfte Pendelungen sind besonders kritisch. Ein Dämpfungskennwert von 0 % entspricht hierbei einer zeitlich unverändert anstehenden Amplitude. Zunehmend positive Werte gehen mit einem immer steiler über die Zeit ansteigenden Verlauf des Amplitudenkennwertes einher. Eine solche Pendelung mit ansteigendem Amplitudenkennwert $\hat{A}$ einer Zustandsgröße in Form einer Phasenwinkeldifferenz ist beispielhaft in Figur 3 dargestellt. Der Dämpfungskennwert $\xi$ der in Figur 3 gezeigten Pendelung liegt bei +10 %. Die Frequenz liegt bei 0,2 Hz.

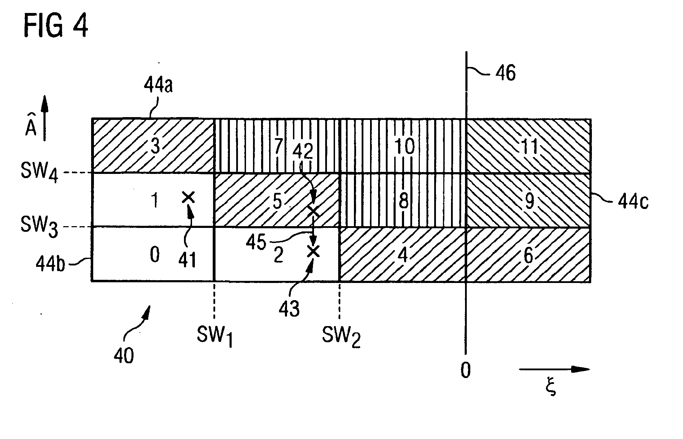

Aus den vorangehenden Ausführungen wird erkennbar, dass Pendelungen je nach Wert ihres Amplitudenkennwertes und ihres Dämpfungskennwertes unterschiedliches Gefährdungspotential für das Energieversorgungsnetz besitzen. Dem Betriebspersonal der Leitstellenweinrichtung ist daher eine möglichst einfache und leicht überschaubare Möglichkeit bereitzustellen, das mit einer aktuellen Pendelung in dem Energieversorgungsnetz verbundene Gefährdungspotential zu erkennen. Um das Gefährdungspotential und damit die möglichen Auswirkungen einer aktuellen Pendelung zu beurteilen, wird daher in der Auswerteinrichtung 13 aus dem Dämpfungskennwert $\xi$ unter Berücksichtigung des aktuellen Amplitudenkennwertes $\hat{A}$ eine Gefährdungskenngröße ermittelt, die das Gefährdungspotenzial charakterisiert. Hierzu wird, wie in Figur 4 beispielhaft angedeutet, ein Wertepaar aus dem aktuellen Wert des Dämpfungskennwertes $\xi$ und dem aktuellen Wert des Amplitudenkennwertes $\hat{A}$ gebildet und die Lage des Wertepaares in einem Wertebereich, der in Figur 4 als Diagramm 40 illustriert ist, eingetragen.

Das Diagramm 40 umfasst eine vorgegebene Anzahl von Gefährdungsbereichen, von denen lediglich beispielhaft zum besseren Verständnis die Gefährdungsbereiche 44a-c in Figur 4 gekennzeichnet sind. Form und Lage der einzelnen Gefährdungsbereiche können über die Konfigurationseinrichtung 14 vom Betriebspersonal vorgegeben werden. Jedem Gefährdungsbereich ist ein eindeutiger Wert einer Gefährdungskenngröße zugeordnet. Konkret ist in Figur 4 beispielsweise dem Gefährdungsbereich 44a eine Gefährdungskenngröße mit dem Wert "3", dem Gefährdungsbereich 44b eine Gefährdungskenngröße mit dem Wert "0" und dem Gefährdungsbereich 44c eine Gefährdungskenngröße mit dem Wert "9" zugeordnet. Die Zuordnung der Werte der Gefährdungskenngröße zu den einzelnen Gefährdungsbereichen kann ebenfalls in der Konfigurationseinrichtung 14 vom Betriebspersonal vorgenommen werden und sollte mit ansteigendem Wert der Gefährdungskenngröße ein ansteigendes Gefährdungspotential der erkannten Pendelung angeben. Generell gilt, dass mit einer Zunahme der Werte von Dämpfungskenngröße und Amplitudenkenngröße eine Erhöhung des Gefährdungspotentials einhergeht. Die Gerade 46 im Diagramm 40 gibt einen Wert von 0 für die Dämpfungskenngröße, und damit den Umschlagpunkt von einer gedämpften Pendelung zu einer ungedämpften Pendelung an.

Zur Ermittlung des für die jeweils aktuelle Pendelung geltenden Wertes der Gefährdungskenngröße wird die Lage des Wertepaares aus Gefährdungskennwert und Amplitudenkennwert in dem durch das Diagramm 40 dargestellten Wertebereich betrachtet. Abhängig von der Lage des Wertepaares in einem der vorgegebenen Gefährdungsbereiche wird der aktuellen Pendelung eine jeweilige Gefährdungskenngröße zugeordnet. Beispielsweise wird einem mit dem Bezugszeichen 41 gekennzeichneten Wertepaar aufgrund seiner Lage im Wertebereich die Gefährdungskenngröße mit dem Wert 1 zugeordnet. Das mit der hierdurch charakterisierten Pendelung verbundene Gefährdungspotential kann aufgrund des relativ geringen Wertes des Dämpfungskennwertes als niedrig eingestuft werden.

Einem mit dem Bezugszeichen 42 gekennzeichnetes Wertepaar wird aufgrund seiner Lage im Diagramm 40 eine Gefährdungskenngröße mit dem Wert 5 zugeordnet. Diesem Wertepaar wird aufgrund des höheren Wertes des Dämpfungskennwertes ein im Vergleich zum Wertepaar 41 erhöhtes Gefährdungspotential beigemessen. Sinkt im Verlauf der Pendelung aufgrund der Dämpfung der Pendelung der Amplitudenkennwert (z.B. entlang des in Figur 4 angedeuteten Pfeils 45), so nimmt mit Eintritt des Wertepaares in den angrenzenden Gefährdungsbereich mit dem Wert 2 der Gefährdungskenngröße das Gefährdungspotential ab.

Dem Betriebspersonal der Leitstelleneinrichtung 10 kann nun von der Leitstelleneinrichtung 10 am Signalausgang 16 abhängig vom Wert der jeweiligen Gefährdungskenngröße ein unterschiedliches eine Pendelung angebendes Signal ausgegeben werden. Das Signal kann hierbei beispielsweise als Datentelegramm ausgegeben werden und (z. B. in textueller und/oder grafischer Form) eine Angabe des jeweils aktuellen Wertes von Amplitudenkennwert, Dämpfungskennwert und Gefährdungskenngröße umfassen. Das die Pendelung angebende Signal kann darüber hinaus auch in unterschiedlicher Form ausgegeben werden, beispielsweise kann das Signal mit steigendem Wert der Gefährdungskenngröße neben dem angesprochenen Informationsgehalt auch weitere akustische oder visuelle Warnhinweise (Alarmton, Blinken, farbliche Kennzeichnung) umfassen. Um das Betriebspersonal nicht mit zu häufigen Signalausgaben abzulenken, kann zudem vorgesehen sein, dass das Signal nur dann ausgegeben wird, wenn eine gewisse Gefährdungskenngröße auch nach Ablauf einer vorgegebenen Verzögerungszeitdauer immer noch ansteht bzw. einen vorgegebenen Minimalwert nicht unterschritten hat. Der Wert der Verzögerungszeit kann als feste Zeitdauer eingestellt werden oder als abzuwartende Anzahl von Pendelperioden - und damit dynamisch von der Pendelfrequenz abhängig - vorgegeben werden.

Außerdem kann vorgesehen sein, dass ein Signal nur dann ausgegeben wird, wenn Amplitudenkennwert und/oder Dämpfungskennwert vorgegebene Schwellenwerte, z.B. die in Figur 4 eingetragenen Schwellenwerte SW1 bis SW4 einzeln oder in Kombination übersteigen. Beispielsweise kann damit festgelegt werden, dass verhältnismäßig harmlose Pendelungen mit Gefährdungskenngrößen mit den Werten 0 (Amplitudenkennwert liegt unterhalb von SW3 und Dämpfungskennwert liegt unterhalb von SW1), 1 (Amplitudenkennwert liegt unterhalb von SW4 und Dämpfungskennwert liegt unterhalb von SW1) und 2 (Amplitudenkennwert liegt unterhalb von SW3 und Dämpfungskennwert liegt unterhalb von SW2) nicht zu einer Ausgabe eines Signals führen. Die einzelnen Schwellenwerte können mit der Konfigurationseinrichtung vorgegeben werden.

Der große Vorteil dieser Art der Bildung des die Pendelung angebenden Signals ist, dass dieses in beliebiger gestufter Weise abhängig von dem aktuellen Amplitudenkennwert und dem aktuellen Dämpfungskennwert erzeugt werden kann und damit dem Betriebspersonal bereits durch das Signal eine differenzierte Information über das mit der aktuellen Pendelung verbundene Gefährdungspotential gegeben werden kann.

Ändert sich der Wert der Gefährdungskenngröße infolge einer hinreichend großen Änderung von Amplitudenkennwert und/oder Dämpfungskennwert, wird die zuletzt gültige Ausgabe des die Pendelung angebenden Signals durch die aktuell gültige Stufe ersetzt.

Für eine höhere Detailliertheit für eine nachfolgende Analyse der Pendelsituation kann der diskrete Wert der Gefährdungskenngröße durch einen quasi-kontinuierlichen Verlauf einer absoluten Gefährdungsgröße $\Psi$ ergänzt werden. Hierzu wird der aktuelle Wert der Gefährdungskenngröße um einen zwischen 0 und 1 liegenden Wert erhöht, der in Abhängigkeit einerseits eines von dem Amplitudenkennwert abhängigen Amplitudenparameters und andererseits eines von dem Dämpfungskennwert abhängigen Dämpfungsparameters ermittelt wird. Beispielsweise können Amplituden- und Dämpfungsparameter wie untern näher dargestellt von der Größe der jeweiligen Grenzwertüberschreitung von Dämpfungskennwert und Amplitudenkennwert abhängen. Der jeweilige Wert dieser absoluten Gefährdungsgröße $\Psi$ kann beispielsweise gemäß den nachfolgend aufgeführten Beziehungen ermittelt werden:

$$\Psi = GKG + k_{\dot{A}} \cdot k_{\varsigma}$$

mit:

GKG = (diskreter) Wert der Gefährdungskenngröße aus dem Diagramm 40;
$k_A$ = Amplitudenparameter;
$k_{\xi}$ = Dämpfungsparameter.

Das Produkt aus dem Amplitudenparameter und dem Dämpfungsparameter ergibt hierbei einen Wert zwischen 0 und 1 der zu der jeweiligen (diskreten) Gefährdungskenngröße hinzuaddiert wird und so einen quasikontinuierlichen Verlauf der absoluten Gefährdungsgröße erlaubt. Lediglich an den Übergängen von einer Gefährdungskenngröße zu einer anderen (z.B. entlang des Pfeils 45 im Diagramm 40) besitzt der Verlauf der absoluten Gefährdungsgröße diskontinuierliche Sprungstellen.

Die Werte für die Amplituden- bzw. Dämpfungsparameter können beispielsweise wie folgt bestimmt werden:

$$k_{\hat{A}} = \frac{\hat{A} - \hat{A}_{SW4}}{\hat{A}} \qquad\qquad \text{für} \qquad \hat{A} \geq \hat{A}_{SW4}$$

$$k_{\hat{A}} = \frac{\hat{A} - \hat{A}_{SW3n}}{\hat{A}_{SW4} - \hat{A}_{SW3}} \qquad\qquad \text{für} \qquad \hat{A}_{SW3} \leq \hat{A} < \hat{A}_{SW4}$$

$$k_{\hat{A}} = \frac{\hat{A}}{\hat{A}_{SW3}} \qquad\qquad \text{für} \qquad \hat{A} < \hat{A}_{SW3}$$

und:

$$k_{\xi} = \frac{\xi}{\xi - \xi_{SW2}} \qquad\qquad \text{für} \qquad \xi \geq 0$$

$$k_{\xi} = \frac{\xi - \xi_{SW2}}{-\xi_{SW2}} \qquad\qquad \text{für} \qquad \xi_{SW2} \leq \xi < 0$$

$$k_{\xi} = \frac{\xi - \xi_{SW1}}{\xi_{SW2} - \xi_{SW1}} \qquad\qquad \text{für} \qquad \xi_{SW1} \leq \xi < \xi_{SW2}$$

$$k_{\xi} = \frac{\xi_{SW1}}{\xi} \qquad\qquad \text{für} \qquad \xi < \xi_{SW1} \,.$$

Die jeweiligen Indizes SW1 bis SW4 beziehen sich auf die Werte des Amplituden- bzw. Dämpfungskennwertes bei dem jeweiligen Schwellenwert (siehe Figur 4).

Die auf diese Weise berechnete absolute Gefährdungsgröße wird zusammen mit den übrigen Kenngrößen der Pendelung als Funktion der Zeit aufgezeichnet und gespeichert. Hierdurch wird die Anzeige und Auswertung des jeweils aktuellen Wertes der absoluten Gefährdungsgröße im Kontext mit den zugehörigen detaillierten Daten während des Betriebes ('online'-Modus) sowie im Rahmen einer späteren Analyse ('offline'-Modus) ermöglicht.

Die beschriebene Art und Weise der Bildung eines eine Pendelung angebenden Signals besitzt den Vorteil einer möglichst hohen Sensibilisierung des Betriebspersonals von Leitstelleneinrichtungen zur Erkennung und genauen Beurteilung von Pendelungen durch eine angemessene Detailliertheit der mit einem Signal zur Verfügung gestellten Information. Diese wird erreicht durch eine den Gefährdungsgrad in vergleichsweise geringer Stufigkeit angegebene Gefährdungskenngröße auf der einen Seite und eine hinreichende, die grundsätzliche Richtung zur Ergreifung möglicher Maßnamen bereits vorgebende, Detailliertheit der den Gefährdungsgrad beschreibenden Kenngrößen auf der anderen Seite.

**Patentansprüche**

1.  Verfahren zum Erzeugen eines eine Pendelung einer elektrischen Größe in einem elektrischen Energieversorgungsnetz angebenden Signals, bei dem folgende Schritte durchgeführt werden:

    - zeitlich synchrones Erfassen von Strom- und oder Spannungszeigermesswerten an zumindest einer Messstelle in dem elektrischen Energieversorgungsnetz mittels einer jeweiligen Zeigermesseinrichtung (12a-c);
    - Übermitteln der Strom- und/oder Spannungszeigermesswerte an eine das Energieversorgungsnetz überwachende Leitstelleneinrichtung (10);
    - Berechnen einer einen Pendelungszustand der elektrischen Größe charakterisierenden Zustandsgröße aus zueinander gehörenden Strom- und/oder Spannungszeigermesswerten mittels der Leitstelleneinrichtung (10);
- Untersuchen eines Verlaufs der Zustandsgröße hinsichtlich einer vorliegenden Pendelung im Energieversorgungsnetz durch die Leitstelleneinrichtung (10) und bei vorliegender Pendelung Durchführung der weiteren Schritte mittels der Leitstelleneinrichtung (10):
- Ermitteln eines eine Amplitude des Verlaufs der Zustandsgröße angebenden Amplitudenkennwertes;

**gekennzeichnet durch** die folgenden Schritte:

- Ermitteln eines eine Dämpfung einer Schwingung des Verlaufs der Zustandsgröße angebenden Dämpfungskennwertes;
- Vergleichen der Lage eines jeweiligen aus einem Amplitudenkennwert und einem zugehörigen Dämpfungskennwert bestehenden Wertepaares mit in einem Wertebereich vorliegenden, einen jeweiligen Gefährdungsgrad der Pendelung in dem Energieversorgungsnetz angebenden Gefährdungsbereichen unter Ermittlung einer Gefährdungskenngröße; und
- Ausgeben des die Pendelung angebenden Signals in Abhängigkeit von der jeweiligen Gefährdungskenngröße.

2. Verfahren nach Anspruch 1,
**dadurch gekennzeichnet, dass**

- die Zustandsgröße eine an einer Messstelle in dem Energieversorgungsnetz vorliegende Wirkleistung angibt.

3. Verfahren nach Anspruch 1,
**dadurch gekennzeichnet, dass**

- die Zustandsgröße eine Phasenwinkeldifferenz angibt, die einen von Spannungszeigermesswerten eingeschlossenen Phasenwinkel bezeichnet, wobei die Spannungszeigermesswerte an zwei unterschiedlichen Messstellen in dem Energieversorgungsnetz zeitlich synchron erfasst worden sind.

4. Verfahren nach einem der vorangehenden Ansprüche,
**dadurch gekennzeichnet, dass**

- der Dämpfungskennwert in Abhängigkeit von der aktuellen Frequenz der Zustandsgröße ermittelt wird.

5. Verfahren nach einem der vorangehenden Ansprüche,
**dadurch gekennzeichnet, dass**

- das die Pendelung angebende Signal nur dann ausgegeben wird, wenn der Amplitudenkennwert und/oder der zugehörige Dämpfungskennwert jeweils einen vorgegebenen Schwellenwert überschreiten.

6. Verfahren nach einem der vorangehenden Ansprüche,
**dadurch gekennzeichnet, dass**

- das die Pendelung angebende Signal Angaben über die aktuelle Frequenz der Zustandsgröße, den aktuellen Amplitudenkennwert der Zustandsgröße, den aktuellen Dämpfungskennwert der Zustandsgröße und/oder die Gefährdungskenngröße enthält.

7. Verfahren nach einem der vorangehenden Ansprüche,
**dadurch gekennzeichnet, dass**

- das die Pendelung angebende Signal in Abhängigkeit von Gefährdungskenngröße in unterschiedlicher Weise ausgegeben wird.

8. Verfahren nach einem der vorangehenden Ansprüche,
**dadurch gekennzeichnet, dass**

- das die Pendelung angebende Signal nur dann ausgegeben wird, wenn die Gefährdungskenngröße auch nach Ablauf einer vorgegebenen Verzögerungszeitdauer einen vorgegebenen Minimalwert nicht unterschritten hat.

**9.** Verfahren nach einem der vorangehenden Ansprüche,
**dadurch gekennzeichnet, dass**

- zeitliche Verläufe der Frequenz der Zustandsgröße, des Amplitudenkennwertes der Zustandsgröße, des Dämpfungskennwertes der Zustandsgröße und/oder einer Angabe der jeweiligen Gefährdungskenngröße in einer Speichereinrichtung (15) der Leitstelleneinrichtung (10) abgespeichert werden.

**10.** Verfahren nach einem der vorangehenden Ansprüche,
**dadurch gekennzeichnet, dass**

- aus der Gefährdungskenngröße und einem von dem Amplitudenkennwert der Zustandsgröße abhängigen Amplitudenparameter sowie einem von dem Dämpfungskennwert der Zustandsgröße abhängigen Dämpfungsparameter eine absolute Gefährdungsgröße berechnet wird, deren Verlauf in einer Speichereinrichtung (15) der Leitstelleneinrichtung (10) abgespeichert wird.

**Claims**

**1.** Method for generating a signal indicating an oscillation of an electrical variable in an electrical energy supply network, wherein the following steps are carried out:

- synchronous recording of current and/or phasor voltage measurement values at least at one measuring site in the electrical energy supply network by means of a respective phasor measuring device (12a-c);
- transmission of the current and/or phasor voltage measurement values to a control centre system (10) monitoring the energy supply network;
- calculation of a state variable characterising an oscillation state of the electrical variable from current and/or phasor voltage measurement values which belong together, by the control centre system (10);
- investigation of a profile of the state variable with regard to an existing oscillation in the energy supply network by the control centre system (10) and, given the existence of an oscillation, carrying out the further steps by the control centre system (10):
- determination of an amplitude characteristic value indicating an amplitude of the profile of the state variable;

**characterised by** the following steps:

- determination of a damping characteristic value indicating a damping of an oscillation of the profile of the state variable;
- comparison of the position of a respective value pair consisting of an amplitude characteristic value and an associated damping characteristic value with hazard ranges present in a value range which indicate a particular hazard level of the oscillation in the energy supply network while determining a hazard parameter; and
- outputting the signal indicating the oscillation, depending on the respective hazard parameter.

**2.** Method according to claim 1,
**characterised in that**

- the state variable indicates an active power level present at a measuring site in the energy supply network.

**3.** Method according to claim 1,
**characterised in that**

- the state variable indicates a phase angle difference which signifies a phase angle enclosed by phasor voltage measurement values, wherein the phasor voltage measurement values have been recorded synchronously at two different measuring sites in the energy supply network.

**4.** Method according to one of the preceding claims,
**characterised in that**

- the damping characteristic value is determined depending on the existing frequency of the state variable.

**5.** Method according to one of the preceding claims,
**characterised in that**

- the signal indicating the oscillation is only output if the amplitude characteristic value and/or the associated damping characteristic value each exceed a respective pre-determined threshold value.

**6.** Method according to one of the preceding claims,
**characterised in that**

- the signal indicating the oscillation contains information concerning the existing frequency of the state variable, the existing amplitude characteristic value of the state variable, the existing damping characteristic value of the state variable and/or the hazard parameter.

**7.** Method according to one of the preceding claims,
**characterised in that**

- the signal indicating the oscillation is output in different ways depending on the hazard parameter.

**8.** Method according to one of the preceding claims,

**characterised in that**

- the signal indicating the oscillation is only output if the hazard parameter has not undershot a pre-determined minimum value even after the expiry of a pre-determined delay period.

**9.** Method according to one of the preceding claims,
**characterised in that**

- chronological profiles of the frequency of the state variable, of the amplitude characteristic value of the state variable, of the damping characteristic value of the state variable and/or an indication of the respective hazard parameter are stored in a storage device (15) of the control centre system (10).

**10.** Method according to one of the preceding claims,
**characterised in that**

- from the hazard parameter and an amplitude parameter dependent on the amplitude characteristic value of the state variable and from a damping parameter dependent on the damping characteristic value of the state variable, an absolute hazard variable is calculated, the profile of which is stored in a storage device (15) of the control centre system (10).


**Revendications**

**1.** Procédé de production d'un signal indiquant une oscillation d'une grandeur électrique dans un réseau de distribution d'énergie électrique, dans lequel on effectue les stades suivants :

- on détecte en synchronisme dans le temps des valeurs de mesure complexes de courant et/ou de tension en au moins un point de mesure du réseau de distribution d'énergie électrique au moyen d'un dispositif (12a-c) de mesure complexe,
- on transmet les valeurs de mesure complexes de courant et/ou de tension à un dispositif (10) de poste de commande contrôlant le réseau de distribution d'énergie,
- on calcule une grandeur d'état caractérisant un état d'oscillation de la grandeur électrique à partir des valeurs de mesure complexes de courant et/ou de tension se correspondant :
- on analyse une courbe de la grandeur d'état en ce qui concerne la présence d'une oscillation dans le réseau d'alimentation d'énergie par le dispositif (10) de poste de commande et, en présence d'une oscillation, on effectue les autres stades au moyen du dispositif (10) de poste de commande,
- on détermine une amplitude de la valeur caractéristique d'amplitude indiquant une amplitude de la courbe de la grandeur d'état,

**caractérisé par** les stades suivants :

- on détermine une valeur caractéristique d'amortissement indiquant un amortissement d'une oscillation de la courbe de la grandeur d'état,
- on compare la position d'une paire de valeurs, constituée d'une valeur caractéristique d'amplitude et d'une valeur caractéristique d'amortissement associée, à des plages de danger présentes dans une plage de valeur et indiquant un degré de danger de l'oscillation dans le réseau de distribution d'énergie en déterminant une grandeur caractéristique de danger et
- on émet le signal indiquant l'oscillation en fonction de la grandeur caractéristique de danger.

2. Procédé suivant la revendication 1, **caractérisé en ce que**

- la grandeur d'état indique une puissance effective présente au point de mesure dans le réseau de distribution d'énergie.

3. Procédé suivant la revendication 1,
**caractérisé en ce que**

- la grandeur d'état indique une différence d'angle de phase, qui caractérise un angle de phase inclus par des valeurs de mesure complexes de tension, les valeurs de mesure complexes de tension ayant été détectées en synchronisme en deux points de mesure différents du réseau de distribution d'énergie.

4. Procédé suivant l'une des revendications précédentes,
**caractérisé en ce que**

- on détermine la valeur caractéristique d'amortissement en fonction de la fréquence présente de la grandeur d'état.

5. Procédé suivant l'une des revendications précédentes,
**caractérisé en ce que**

- on n'émet le signal indiquant l'oscillation que si la valeur caractéristique d'amplitude et/ou la valeur caractéristique d'amortissement associée dépassent chacune une valeur de seuil donnée à l'avance.

6. Procédé suivant l'une des revendications, **caractérisé en ce que**

- le signal indiquant l'oscillation contient des indications sur la fréquence présente de la grandeur d'état, sur la valeur caractéristique d'amplitude présente de la grandeur d'état, sur la valeur caractéristique d'amortissement présente de la grandeur d'état et/ou sur la grandeur caractéristique de danger.

7. Procédé suivant l'une des revendications précédentes,
**caractérisé en ce que**

- on émet de manière différente le signal indiquant l'oscillation en fonction de la grandeur caractéristique de danger.

8. Procédé suivant l'une des revendications précédentes,
**caractérisé en ce que**

- on n'émet le signal indiquant l'oscillation que si la grandeur caractéristique de danger n'est pas devenue, après l'écoulement d'une durée de retard donnée à l'avance, inférieure à une valeur minimum donnée à l'avance.

9. Procédé suivant l'une des revendications précédentes,
**caractérisé en ce que**

- on mémorise dans un dispositif (15) de mémoire du dispositif (10) de poste de commande des courbes en fonction du temps de la fréquence de la grandeur d'état, de la valeur caractéristique de l'amplitude de la grandeur d'état, de la valeur caractéristique d'amortissement de la grandeur d'état et/ou une indication de la grandeur caractéristique de danger.

10. Procédé suivant l'une des revendications précédentes,
**caractérisé en ce que**
on calcule à partir de la grandeur caractéristique de danger et d'un paramètre d'amplitude dépendant de la valeur caractéristique d'amplitude de la grandeur d'état, ainsi que d'un paramètre d'amortissement dépendant de la valeur caractéristique d'amortissement de la grandeur d'état, une grandeur de danger absolue, dont on mémorise la courbe dans un dispositif (15) de mémoire du dispositif (10) de poste de commande.

## FIG 1

## FIG 2

## FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011032579 A1
- EP 1489714 B1